# EUROPÄISCHE PATENTSCHRIFT

(11) **EP 2 802 195 B1**
(45) Veröffentlichungstag und Bekanntmachung des Hinweises auf die Patenterteilung: **26.08.2020**
(21) Anmeldenummer: 14163074.9
(22) Anmeldetag: 01.04.2014
(51) Int. Cl.: H05K 7/14

(54) **Elektronikgehäuse für Schaltgeräte mit integrierten Klemmkontakten**
Electronics housing for switching devices with integrated terminal contacts
Boîtier électronique pour commutateurs avec contacts de serrage intégrés

(30) Priorität: 06.05.2013 DE 102013208273
(43) Veröffentlichungstag der Anmeldung: 12.11.2014
(73) Patentinhaber: Siemens Aktiengesellschaft, 80333 München (DE)
(72) Erfinder: Geitner, Manuel, 92289 Ursensollen (DE); Holmer, Wolfgang, 92421 Schwandorf (DE); Richter, Bernhard, 92224 Amberg (DE); Töpert, Gerhard, 92224 Amberg (DE)

(56) Entgegenhaltungen:
- WO-A1-00/08722
- DE-A1- 19 851 455
- DE-B4-102006 025 977
- DE-T2- 69 306 620
- DE-U1- 7 605 140
- DE-U1- 29 713 698

## Beschreibung

Die Erfindung betrifft ein Elektronikgehäuse für Schaltgeräte mit darin angeordneten elektronischen Flachbaugruppen, wobei das Elektronikgehäuse von außen über elektrische Leiter kontaktierbar ist.

Modulare Elektronikkomponenten benötigen eine funktionsgerechte Einhäusung, die unterschiedliche Einstell- und Bedienfunktionen zulässt und möglichst einfach aber dennoch zuverlässig montierbar ist. Mit dem Trend zunehmender Steuerung und Automatisierung von Abläufen insbesondere im industriellen Bereich bei gleichzeitiger Dezentralisierung der Elektronik direkt in den Prozess sowie der Miniaturisierung von Elektronikbaugruppen zu kompakten, montagefreundlichen Geräten werden daher zunehmend geeignete Elektronikgehäuse benötigt, wobei in der Regel dann auch die Anschlusstechnik im Gehäuse integriert ist oder abnehmbar ist. Die einzelnen elektronischen Geräte können dabei in der Regel direkt auf einer Tragschiene montiert und bevorzugt über ein Bussystem miteinander und mit einer Steuerung verbunden werden.

Hierbei gibt es je nach Anwendungsfall eine Vielzahl von unterschiedlichen elektronischen Geräten und Gehäuseformen, die sich in ihrer Größe, ihrem Aufbau und ihrer Funktion unterscheiden. Diese elektronischen Geräte weisen jedoch alle die Gemeinsamkeit auf, dass in ihrem Inneren elektronische Baugruppen, meistens in Form von Flachbaugruppen, angeordnet sind, welche durch das Elektronikgehäuse vor Berührung und Schmutz geschützt werden. Derartige Gehäuse sind meist modular aufgebaut, so dass ein Einsetzen oder Austauschen einer Leiterplatte und damit das Anpassen des elektronischen Geräts an unterschiedliche Bedingungen schnell und einfach möglich ist.

Häufig bestehen die Gehäuse aus einem Gehäuseoberteil und einem Gehäuseunterteil, wobei das Gehäuseoberteil Anschlüsse für elektrische Leitungen aufweist. Die einzelnen Gehäuse sind dabei so ausgebildet, dass mehrere Gehäuse benachbart zueinander auf einer Tragschiene aufrastbar sind, so dass mehrere Gehäuse zusammen einen Gehäuseblock bilden. Dabei sind die einzelnen benachbarten Gehäuse beziehungsweise die einzelnen benachbarten elektronischen Geräte vorzugsweise elektrisch miteinander kontaktierbar.

Ein wesentlicher technischer Aspekt dieser Elektronikgehäuse besteht darin, eine zuverlässige elektrische Verbindung zwischen von außen eingeführten Leitern und im Inneren des Elektronikgehäuses platzierten Flachbaugruppen zu gewährleisten. Zum Anschluss von Leitern an Elektronikgehäusen kommt allgemein ein Schnittstellenteil auf der Flachbaugruppe zum Einsatz, welches die Verbindung zwischen Anschlussseite und Funktion herstellt. Im Allgemeinen wird dafür ein Klemmenträger verwendet, der als Kunststoffkörper mit eingelegten und eingespritzten Kontaktelementen ausgebildet ist und der auf der Flachbaugruppe befestigt ist. In der Fertigung erfordert dies einen Mehraufwand an Handling, Positionierung, Lötung und weiteren Arbeitsschritten.

Klemmenträger für THT- beziehungsweise THR-Prozesse bestehen in diversen Formen am Markt. Die Funktion des Klemmenträgers wird jedoch in allen bekannten Fällen in Form eines zusätzlichen Elements wahrgenommen. Als Verbindungstechnologie sind Löt-, Steck- und Einpresstechnik bekannt.

Für den eingeführten Lötprozess sind spezielle Lötrahmen oder Niederhalter notwendig, um den Klemmenträger sicher zu positionieren und diese Position nach dem Durchlauf des Lötprozesses zu gewährleisten. Hier entstehen hohe Kosten für die Fixierhilfen in Form mechanisch gefederter Niederhalter. Die Niederhalter müssen je nach Bestückung der Flachbaugruppen neu erstellt werden. Begründet ist dies durch unterschiedlich hohe Bauteile auf den Flachbaugruppen, zum Beispiel Lötmasken für Schwalllötungen.

Ein ähnliches Prinzip beruht auf der Technologie des Card Edge Verbinders. Der auf die Leiterplatte lötbare, steckbare oder eingepresste Verbinder verfügt in seinem Kunststoffgehäuse über Tulpenkontakte, welche durch Aufschieben auf Kupferpads eine Verbindung herstellen. Der Löt-/Steck-/oder Einpressprozess wird hier zusätzlich benötigt. Auf Grund des zusätzlichen Prozesses ist somit auch ein separater Kunststoffkörper erforderlich.

Die DE 297 13 698 U1 zeigt ein elektrisches Gerät mit einem elektrische, elektromechanische und/oder elektronische Bauteile aufnehmendem Gehäuse und dazu angeordneten elektrischen Anschlüssen, wobei den Anschlüssen Verbindungsleiter zugehörig sind, die lötbare Kontaktstifte aufweisen, die mit Lötkontakten der auf einer Leiterplatte im Gehäuse vorgesehenen Bauteile im Wesentlichen in einer gemeinsamen Ebene angeordnet sind.

Die WO 00/08722 beschreibt ein Mobiltelefon mit einem Gehäuse, in welchem eine Flachbaugruppe über Kontaktelemente elektrisch kontaktiert wird. Die Enden der Kontaktelemente kontaktieren dabei elektrische Kontaktpads auf der Flachbaugruppe.

Aus der DE 198 51 455 A1 geht ein Elektronikmodul mit einem Gehäuse hervor, in welchem eine Leiterplatte über ein Steckerteil elektrisch kontaktiert wird. Die Enden der Leistungsstromleiter sowie der Anschlussleitungen des Steckerteils werden in die Leiterplatte eingepresst.

Die DE 10 2006 025 977 B4 zeigt ein Steuergerät mit einem Gehäuse, in welchem ein Schaltungsträger über Steckerkontaktteile eines Steckerteils elektrisch kontaktiert wird.

Demgemäß besteht die Aufgabe der vorliegenden Erfindung darin, ein Elektronikgehäuse für Schaltgeräte zu schaffen, welches eine einfache elektrische Kontaktierung zwischen von außen eingeführten elektrischen Leitern und im Inneren des Elektronikgehäuses positionierten Flachbaugruppen ermöglicht.

Diese Aufgabe wird erfindungsgemäß durch ein Elektronikgehäuse für ein Schaltgerät mit den Merkmalen des Patentanspruchs 1 gelöst. Weitere Ausführungsbeispiele der Erfindung ergeben sich aus den Unteransprüchen, der Beschreibung sowie der Zeichnung. Merkmale und Details, die im Zusammenhang mit dem Elektronikgehäuse beschrieben sind, gelten dabei auch im Zusammenhang mit dem Schaltgerät und umgekehrt.

Erfindungsgemäß wird diese Aufgabe durch ein Elektronikgehäuse für ein Schaltgerät mit darin angeordneten elektronischen Flachbaugruppen gelöst, wobei das Elektronikgehäuse von außen über elektrische Leiter kontaktierbar ist. Die Erfindung zeichnet sich dadurch aus, dass die elektrische Kontaktierung zwischen Leiter und Flachbaugruppe direkt über ein im Kunststoffgehäuse des Elektronikgehäuses angeordnetes Kontaktelement ausgebildet ist.

Erfindungsgemäß kann vorgesehen sein, dass das Kontaktelement im Elektronikgehäuse eingepresst ist, um eine sichere Positionierung des Kontaktelements zu gewährleisten.

In einem zweiten Ausführungsbeispiel der Erfindung ist es jedoch auch möglich, dass das Kontaktelement von Kunststoffwandungen des Elektronikgehäuses umspritzt ist. Auch die Umspritzung des Kontaktelementes führt dazu, dass das Kontaktelement sicher positioniert ist.

Es kann erfindungsgemäß weiterhin vorgesehen sein, dass das Kontaktelement variabel auf die jeweiligen Strom- beziehungsweise Spannungsverhältnisse anpassbar ist. Diese Anpassung kann insbesondere durch die Materialzusammensetzung des Kontaktelements erfolgen.

Weiterhin kann ein wesentlicher technischer Vorteil derart ausgebildet sein, dass auf der vom Kontaktelement zum Leiter nach außen führenden Seiten eine Kontaktfläche in Form einer Kontaktfahne angeordnet ist. Diese Kontaktfahne ermöglicht eine zuverlässige elektrische Verbindung zwischen Leiter und Flachbaugruppe.

In einer weiteren technischen Ausgestaltung der Erfindung kann vorgesehen sein, dass auf der vom Kontaktelement zum Leiter nach außen führenden Seite eine Kontaktfläche in Form eines Pins angeordnet ist. Auch diese Ausgestaltung ermöglicht eine zuverlässige elektrische Verbindung zwischen Leiter und Flachbaugruppe im Inneren des Elektronikgehäuses.

Es kann weiterhin vorgesehen sein, dass auf der vom Kontaktelement zur Flachbaugruppe nach innen führenden Seite eine selbstklemmende Kontaktierung in Form eines Tulpenkontakts ausgebildet ist. Über diese selbstklemmende Kontaktierung wird eine zuverlässige elektrische Verbindung zwischen Kontaktelement und Flachbaugruppe gewährleistet.

In einer weiteren bevorzugten Ausführungsform der Erfindung kann vorgesehen sein, dass das Kontaktelement eine Kupfer/Zink-Zusammensetzung aufweist.

Die Erfindung umfasst außerdem ein Schaltgerät, insbesondere ein Niederspannungsschaltgerät, das ein Elektronikgehäuse mit den oben aufgeführten Merkmalen aufweist.

Das erfindungsgemäße Elektronikgehäuse für Schaltgeräte, insbesondere für Niederspannungsschaltgeräte, weist vorzugsweise ein aus Kunststoff gefertigtes Gehäuse auf mit einem vorzugsweise quaderförmigen Aufbau, wobei an einer Außenseite ein Anschlussbereich mit Anschlussklemmen für den Anschluss von elektrischen Leitern vorgesehen ist. Im Inneren sind vorzugsweise parallel zueinander angeordnete Flachbaugruppen, vorzugsweise aus Leiterplatten positioniert. An dem Seitenteil, insbesondere Oberteil des Elektronikgehäuses, an welchem au-ßenseitig der Anschlussbereich mit Anschlussklemmen angeordnet ist, sind innenseitig Kontaktelemente positioniert.

Die eingelegten oder eingepressten oder umspritzten erfindungsgemäßen Kontaktelemente sind je nach Anwendungsfall, das heißt, je nach Strom- beziehungsweise Spannungsverhältnissen individuell ausgeprägt. Die erfindungsgemäßen Kontaktelemente können jede mögliche Form annehmen und sind im vorliegenden Ausführungsbeispiel vorzugsweise in Z-Form ausgebildet.

Auf der vom Kontaktelement zum Leiter nach außen führenden Seite ist eine Kontaktfläche vorzugsweise in Form einer Kontaktfahne oder eines Pins angeordnet. Auf der vom Kontaktelement zur Flachbaugruppe nach innen führenden Seite ist eine selbstklemmende Kontaktierung, vorzugsweise in Form eines Tulpenkontakts angeordnet. Diese Geometrie trifft im Gehäuse auf Kontaktflächen, die auf der Flachbaugruppe angeordnet sind, vorzugsweise sind es Kupferpads, die die Verbindung über den Kontakt zur Anschlussklemme herstellen.

Durch Entfall des Lötprozesses entstehen keine weiteren Nacharbeitungsschritte durch schlechte Lötstellen. Die konstruktive Ausarbeitung des Kontaktelements zum Beispiel als Tulpenkontakt ist so gestaltet, dass dieser alle Fertigungstoleranzen ausgleicht und somit eine sichere Kontaktierung bildet.

Die Erfindung zeichnet sich dadurch aus, dass ein separater Klemmenträger eingespart werden kann. Ein weiterer wesentlicher Vorteil der Erfindung besteht darin, dass ein zusätzlicher Arbeitsschritt bei der Herstellung der Flachbaugruppe entfällt. Der nicht mehr benötigte Lötprozess, der zu einem erheblichen Mehraufwand führte und eine verlängerte Abkühlphase erforderlich machte, kann eingespart werden. Ebenso können die Kosten für Niederhalter eingespart werden. Die vorliegende Erfindung zeichnet sich insbesondere durch eine verbesserte Montierbarkeit und schnellere Durchlaufzeiten durch unkompliziertes Aufschieben des Kontaktes auf die Flachbaugruppe aus.

Weitere Vorteile und Ausführungen der Erfindung werden nachfolgend anhand eines Ausführungsbeispiels sowie anhand der Zeichnung erläutert.

Dabei zeigen schematisch:

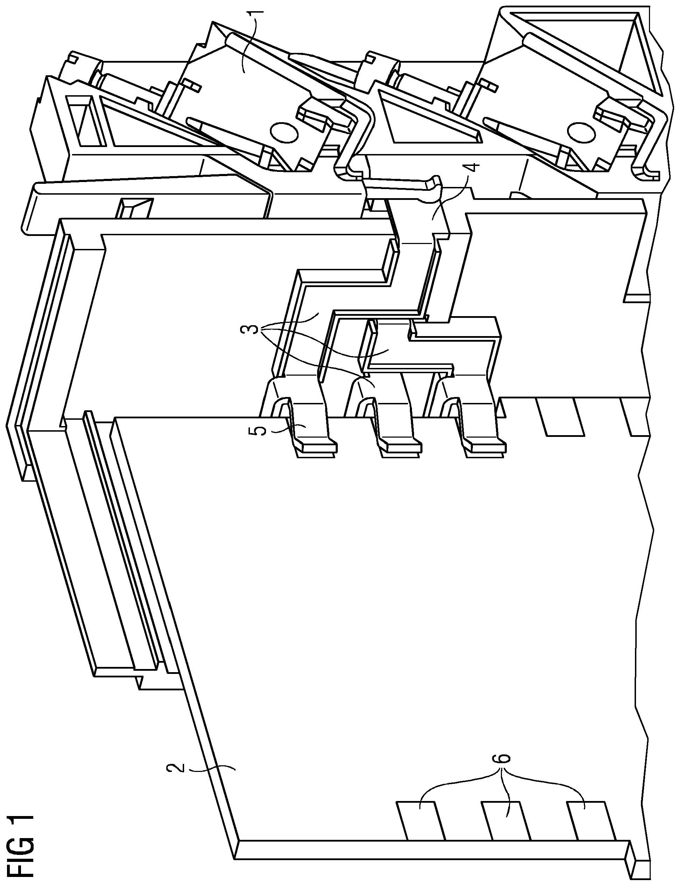

Fig. 1 in einer perspektivischen Darstellung ein Ausführungsbeispiel eines erfindungsgemäßen Elektronikgehäuses mit integrierten Klemmkontakten;
Fig. 2 in einer perspektivischen Darstellung das erfindungsgemäße Elektronikgehäuse nach Fig. 1 mit selbstklemmender Kontaktierung in Form eines Tulpenkontakts für die Flachbaugruppenkontaktierung;
Fig. 3 in einer perspektivischen Darstellung eine in einer selbstklemmenden Kontaktierung positionierte Flachbaugruppe.

Das erfindungsgemäße Elektronikgehäuse für Schaltgeräte, insbesondere für Niederspannungsschaltgerät weist vorzugsweise ein aus Kunststoff gefertigtes Gehäuse auf mit einem vorzugsweise quaderförmigen Aufbau, wobei an einer Außenseite ein Anschlussbereich mit Außenklemmen 1 für den Anschluss von elektrischen Leitern vorgesehen ist. Im Inneren sind vorzugsweise parallel zueinander angeordnete Flachbaugruppen 2, vorzugsweise aus Leiterplatten positioniert. An dem Seitenteil, insbesondere Oberteil des Elektronikgehäuses, an welchem au-ßenseitig der Anschlussbereich mit den Anschlussklemmen 1 angeordnet ist, sind innenseitig Kontaktelemente 3 positioniert.

Die eingelegten oder eingepressten oder umspritzten erfindungsgemäßen Kontaktelemente 3 sind je nach Anwendungsfall, das heißt, entsprechend den Strom- beziehungsweise Spannungsverhältnissen, individuell ausgeprägt. Die erfindungsgemäßen Kontaktelemente 3 können jede Form annehmen und sind im vorliegenden Ausführungsbeispiel vorzugsweise in Z-Form ausgebildet.

Auf der vom Kontaktelement 3 zum Leiter nach außen führenden Seite ist eine Kontaktfläche 4, vorzugsweise in Form einer Kontaktfahne oder eines Pins angeordnet. Auf der vom Kontaktelement 3 zur Kontaktbaugruppe 2 nach innen führenden Seite ist eine selbstklemmende Kontaktierung, vorzugsweise in Form eines Tulpenkontakts 5 angeordnet. Diese Geometrie trifft im Gehäuse auf Kontaktflächen 6, die auf der Flachbaugruppe 2 angeordnet sind, vorzugsweise sind es Kupferpads, die die Verbindung zur Anschlussklemme 1 herstellen.

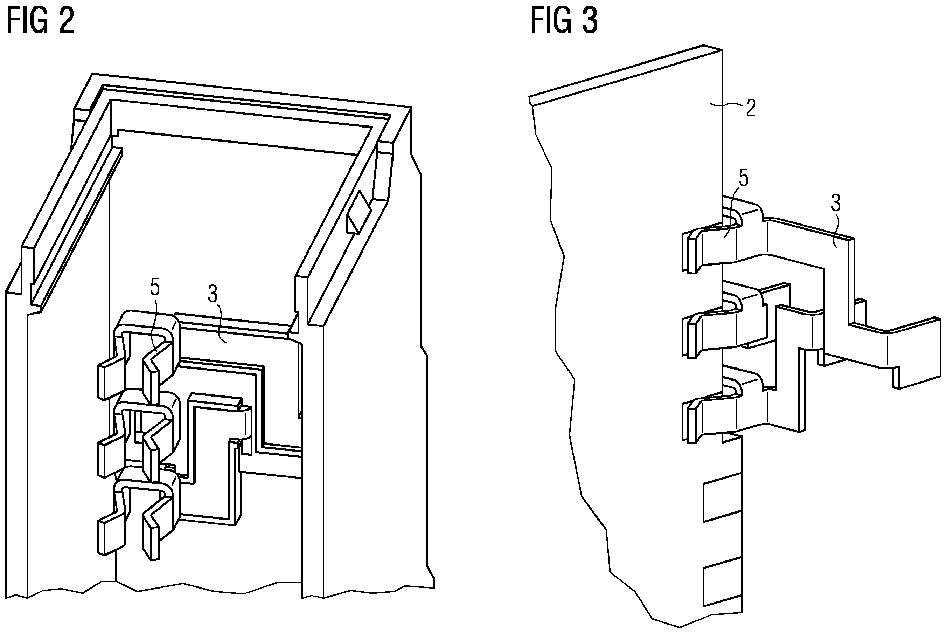

Fig. 2 zeigt einen Ausschnitt eines erfindungsgemäßen Elektronikgehäuses, wobei die elektrische Verbindung zwischen der selbstklemmenden Kontaktierung in Form eines Tulpenkontakts 5 für die Flachbaugruppe 2 und dem erfindungsgemäßen Kontaktelement 3 dargestellt ist.

Fig. 3 zeigt die im Tulpenkontakt 5 positionierte Flachbaugruppe 2 inklusive der Verbindung zu den Kontaktelementen 3.

Die Erfindung zeichnet sich dadurch aus, dass ein separater Klemmenträger eingespart werden kann. Ein weiterer wesentlicher Vorteil der Erfindung besteht darin, dass ein zusätzlicher Arbeitsschritt bei der Herstellung der Flachbaugruppe entfällt. Der nicht mehr benötigte Lötprozess, der zu einem erheblichen Mehraufwand führte und eine verlängerte Abkühlphase erforderlich machte, kann eingespart werden. Ebenso können die Kosten für Niederhalter eingespart werden. Die vorliegende Erfindung zeichnet sich insbesondere durch eine verbesserte Montierbarkeit und schnellere Durchlaufzeiten durch unkompliziertes Aufschieben des Kontaktes auf die Flachbaugruppe aus.

## Patentansprüche

1. Elektronikgehäuse für Schaltgeräte mit darin angeordneten elektronischen Flachbaugruppen (2), wobei das Elektronikgehäuse von außen über elektrische Leiter kontaktierbar ist, wobei an einer Außenseite ein Anschlussbereich mit Außenklemmen (1) für den Anschluss von elektrischen Leitern vorgesehen ist, **wobei** die elektrische Kontaktierung zwischen Leiter und Flachbaugruppe (2) direkt über ein im Kunststoffgehäuse des Elektronikgehäuses
angeordnetes Kontaktelement (3) ausgebildet ist, das mit den Außenklemmen elektrisch verbunden ist,
wobei das Kontaktelement (3) im Elektronikgehäuse eingepresst ist oder von Kunststoffwandungen des Elektronikgehäuses umspritzt ist,
und wobei auf der vom Kontaktelement (3) zur Flachbaugruppe (2) nach innen führenden Seite des Kontaktelements eine selbstklemmende Kontaktierung (5) in Form eines Lückenkontakts zur selbstklemmenden Verbindung mit Kontaktflächen auf einer Flachbaugruppe ausgebildet ist.

2. Elektronikgehäuse nach Anspruch 1, **dadurch gekennzeichnet, dass** das Kontaktelement (3) eine an die Strom- beziehungsweise Spannungsverhältnisse angepasste Materialzusammensetzung aufweist.

3. Elektronikgehäuse nach Anspruch 1 oder 2, **dadurch gekennzeichnet, dass** auf der von Kontaktelement (3) zum Leiter nach außen führenden Seite eine Kontaktfläche (4) in Form einer Kontaktfahne angeordnet ist.

4. Elektronikgehäuse nach einem der Ansprüche 1 bis 3, **dadurch gekennzeichnet, dass** auf der vom Kontaktelement (3) zum Leiter nach außen führenden Seite eine Kontaktfläche (4) in Form eines Pins angeordnet ist.

5. Elektronikgehäuse nach einem der Ansprüche 1 bis 4, **dadurch gekennzeichnet, dass** das Kontaktelement (3) eine Kupfer/Zink-Zusammensetzung aufweist.

6. Schaltgerät, insbesondere ein Niederspannungsschaltgerät, aufweisend ein Elektronikgehäuse mit den Merkmalen der Patentansprüche 1 bis 5.

## Claims

1. Electronic housing for switchgears with electronic flat modules (2) arranged therein, wherein contact can be made with the electronic housing from the outside via electrical conductors, wherein a connection region with outer terminals (1) for connecting electrical conductors is provided on an outer side, wherein the electrical contacting between the conductor and the flat module (2) is formed directly via a contact element (3) which is arranged in the plastic housing of the electronic housing and is electrically connected to the outer terminals, wherein the contact element (3) is pressed into the electronic housing or is encapsulated by plastic walls of the electronic housing, and wherein self-clamping contacting (5) in the form of a gap contact for the self-clamping connection to contact areas on a flat module is formed on that side of the contact element which leads to the inside from the contact element (3) to the flat module (2).

2. Electronic housing according to Claim 1, **characterized in that** the contact element (3) has a material composition adapted to the current and/or voltage conditions.

3. Electronic housing according to Claim 1 or 2, **characterized in that** a contact area (4) in the form of a contact lug is arranged on the side leading to the outside from the contact element (3) to the conductor.

4. Electronic housing according to one of Claims 1 to 3, **characterized in that** a contact area (4) in the form of a pin is arranged on the side leading to the outside from the contact element (3) to the conductor.

5. Electronic housing according to one of Claims 1 to 4, **characterized in that** the contact element (3) has a copper/zinc composition.

6. Switchgear, in particular low-voltage switchgear, having an electronic housing with the features of Patent Claims 1 to 5.

## Revendications

1. Boîtier électronique pour appareils de commutation avec des modules plats (2) électroniques agencés dedans, le boîtier électronique pouvant être contacté depuis l'extérieur via des conducteurs électriques, sur un côté extérieur étant prévue une zone de raccordement avec des bornes externes (1) pour le raccordement de conducteurs électriques, le contact électrique entre conducteur et module plat (2) étant réalisé directement via un élément de contact (3) agencé dans le boîtier en matière plastique du boîtier électronique, lequel élément est relié électriquement aux bornes externes, l'élément de contact (3) étant comprimé dans le boîtier électronique ou surmoulé par des parois en matière plastique du boîtier électronique, et sur le côté de l'élément de contact allant de l'élément de contact (3) vers le module plat (2) vers l'intérieur étant réalisé un contact autoserrant (5) en tant que contact discontinu pour connexion autoserrante avec des surfaces de contact sur un module plat.

2. Boîtier électronique selon la revendication 1, **caractérisé en ce que** l'élément de contact (3) présente une composition de matériaux adaptée aux rapports de courant resp. de tension.

3. Boîtier électronique selon la revendication 1 ou 2, **caractérisé en ce qu'**est agencée, sur le côté allant de l'élément de contact (3) vers le conducteur vers l'extérieur, une surface de contact (4) en forme de languette de contact.

4. Boîtier électronique selon l'une des revendications 1 à 3, **caractérisé en ce qu'**est agencée, sur le côté allant de l'élément de contact (3) vers le conducteur vers l'extérieur, une surface de contact (4) en forme de broche.

5. Boîtier électronique selon l'une des revendications 1 à 4, **caractérisé en ce que** l'élément de contact (3) présente une composition de cuivre et de zinc.

6. Appareil de commutation, et plus particulièrement appareil de commutation basse tension, comprenant un boîtier électronique présentant les caractéristiques des revendications 1 à 5.
